# EUROPEAN PATENT APPLICATION

(11) **EP 2 426 238 A1**
(43) Date of publication of application: **07.03.2012**
(21) Application number: 09844018.3
(22) Date of filing: 30.04.2009
(51) Int. Cl.: C30B 19/04, C30B 29/36

(54) **METHOD FOR FABRICATING SiC SUBSTRATE**

(71) Applicant: Ecotron Co., Ltd., Ukyo-ku Kyoto-shi Kyoto 615-8686 (JP)
(72) Inventor: HAMADA, Shinkichi, Kyoto-shi Kyoto 615-8686 (JP); NAKAMURA, Nobuhiko, Kyoto-shi Kyoto 615-8686 (JP); MATSUNAMI, Toru, Kyoto-shi Kyoto 615-8686 (JP)
(74) Representative: Vossius & Partner
(86) International application number: PCT/JP2009/058474
(87) International publication number: WO 2010/125674

(57) **Abstract**

A method for fabricating a SiC substrate using metastable solvent epitaxy comprises a Si evaporation step of evaporating a Si melt at an intermediate temperature between a SiC crystal growth temperature and a Si melting point after a crystal growth step of growing an SiC crystal with a predetermined film thickness on the surface of the SiC substrate at the SiC crystal growth temperature. In the method for fabricating the SiC substrate, the ambient pressure in the crystal growth step is higher than the saturated vapor pressure of the Si melt, and the ambient pressure in the Si evaporation step is lower than the saturated vapor pressure of the Si melt. Single-crystal SiC with no large irregularities on the surface thereof can be obtained by using the method.

## Description

### [Technical Field]

The present invention relates to a method for fabricating a SiC substrate, and more particularly, it relates to a method for fabricating a SiC substrate by employing metastable solvent epitaxy.

### [Background Art]

Since there are stiff user requirements for high efficiency of electric equipment in recent years, semiconductor materials with a higher withstand voltage are being developed for semiconductor devices. In particular, since SiC (silicon carbide) has a larger band gap than Si (silicon), its application to power devices of the next generation has been studied earnestly.

As typical methods for obtaining single crystal SiC used for fabricating a SiC semiconductor device, chemical vapor deposition (CVD), liquid growth method, sublimation technique(modified lely method) and the like are known. Among these methods, the liquid growth method is known as a method by which single crystal SiC with high quality may be obtained at a comparatively high growth speed. This liquid growth method is, however, performed at a high temperature exceeding 1000°C using a Si-based flux, and therefore, it is necessary to control the convection and the temperature in liquid (Si melt), and a method for such control is a significant problem.

As a growth method by which this problem is solved, metastable solvent epitaxy (hereinafter sometimes referred to as the "MSE") has been proposed (in, for example, Patent Document 1).

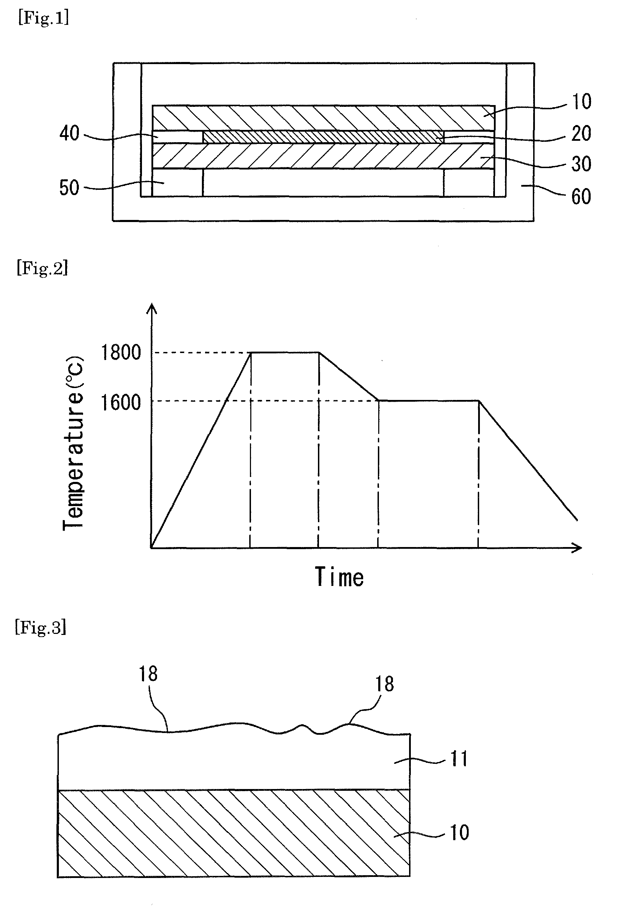

The growth of SiC performed by employing the MSE will be specifically described with reference to FIG. 1 schematically illustrating a main part of an apparatus for growing single crystal SiC used in the MSE. As illustrated in FIG. 1, a single crystal SiC substrate 10 (seed crystal) used as a growth substrate, a very thin Si layer 20 (in a solid state up to a melting point of Si and in a liquid state above the melting point of Si), an upper spacer 40 for controlling the thickness of the Si layer 20, a carbon atom supply substrate 30 used as a material supplying substrate and a lower spacer 50 are disposed in this order in a downward direction in a closed crucible 60.

The SiC growth through the MSE is performed in a high vacuum atmosphere, and first, the temperature within the crucible 60 is increased by using heating means not shown up to a prescribed temperature (a SiC growth temperature) higher than the melting point of Si (of approximately 1400°C). During this temperature increase, when the temperature exceeds the melting point of Si, the solid Si of the Si layer 20 is melted into a Si melt. Subsequently, the temperature is kept for a prescribed period of time, during which single crystal SiC is grown on the single crystal SiC substrate 10. Thereafter, the temperature is lowered, and the single crystal SiC substrate 10 on which the single crystal SiC has been grown is taken out.

In this manner, the heating process is carried out at a high temperature with the very thin Si layer 20 (i.e., a Si melt layer) disposed between the single crystal SiC substrate 10 and the carbon atom supply substrate 30, and thus, the single crystal SiC may be epitaxially grown on the single crystal SiC substrate 10.

Since the very thin Si melt layer is formed between the single crystal SiC substrate (i.e., the SiC growth substrate) and the carbon atom supply substrate (i.e., the material supplying substrate) in the MSE, this method is characterized by suppression of convection in the Si melt. Furthermore, since the very thin Si melt layer is formed to be sandwiched between the substrates, the Si melt layer may be held merely by surface tension of the Si melt, and hence, there is no need to provide a vessel for holding the Si melt. Moreover, since driving force for growing the SiC does not depend upon a spatial temperature difference or a temporal temperature difference, a soaking area may be easily attained without performing careful temperature control.

In the MSE having the aforementioned excellent characteristics, since the heating process is performed at a high temperature, not only a film with a large thickness may be obtained by increasing the growth speed of the crystal but also an effect to suppress propagation of a defect may be attained, and therefore, single crystal SiC with high quality may be fabricated. When Si remains after the growth of the single crystal SiC, however, the Si is solidified in lowering the temperature and the Si is expanded in solidifying. Hence, large stress is caused in the single crystal SiC substrate, resulting in causing a new defect.
Accordingly, it is necessary to evaporate remaining Si entirely after growing single crystal SiC at a high temperature in the MSE.

### [Prior Art Document]

### [Patent Document 1]

Patent Document 1: JP 2005-126249A

### [Summary of the Invention]

### [Problem to be Solved by the Invention]

In the aforementioned MSE, however, irregularities are caused in a surface portion of the SiC substrate during evaporation of Si, and the single crystal SiC substrate taken out may not be directly used for a device but it is necessary to carry out polishing to make it flat.

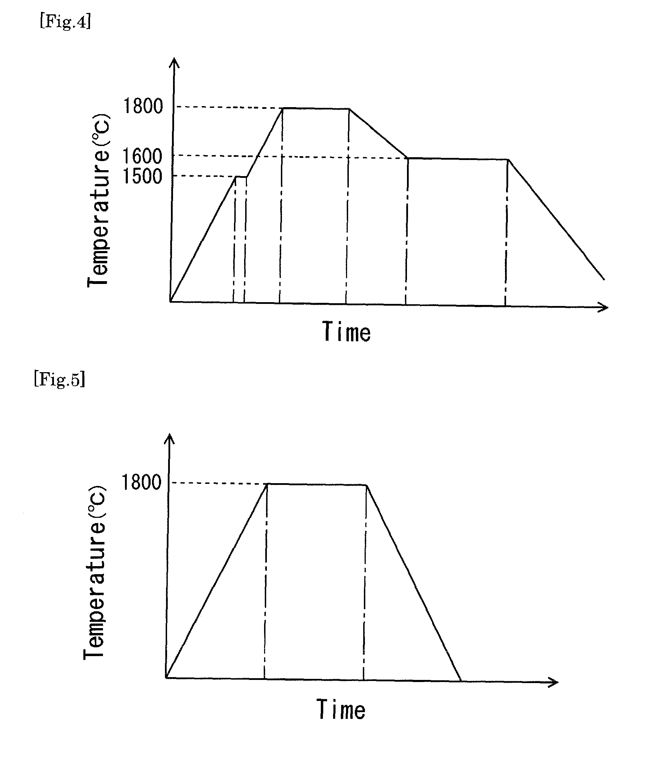

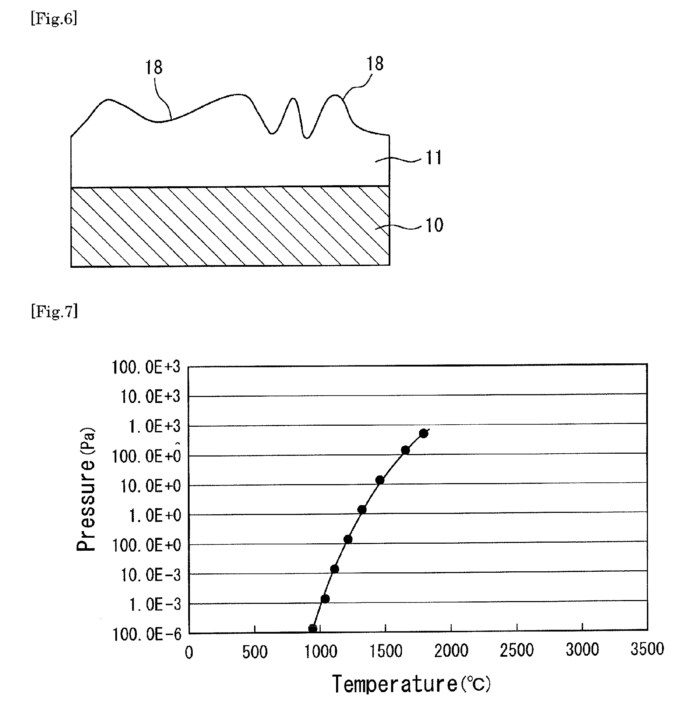

A single crystal SiC substrate obtained through the MSE growth, for example, with a temperature profile of FIG. 5 by using the apparatus of FIG. 1 is illustrated in FIG. 6. As illustrated in FIG. 6, large irregularities of approximately 10 µm are formed in a surface portion of the obtained single crystal SiC substrate. Heating times of FIG. 5 are 3 hours for increasing the temperature to 1800°C, 4 hours for keeping the temperature of 1800°C and 10 hours for lowering the temperature to room temperature, and while the temperature of 1800° is being kept, the SiC crystal is grown on the SiC substrate and entire remaining Si is evaporated. In FIG. 5, a reference numeral 10 denotes the aforementioned single crystal SiC substrate, a reference numeral 11 denotes single crystal SiC grown through the MSE and a reference numeral 18 denotes irregularities caused in a surface portion.

In order to use the thus obtained single crystal SiC for a device, it is necessary to make the irregularities flat by polishing it. Since there are large irregularities in a surface portion, however, it is difficult to measure the thickness optically, namely, non-destructively, and hence, a margin for the polishing may not be accurately determined. When there are large irregularities, the amount of polished crystal is also large and the thickness of resultant single crystal SiC is reduced, which increases the cost. In some cases, it is apprehended that entire single crystal SiC may be removed through the polishing.

Accordingly, it has been desired to develop a technique to grow single crystal SiC having a sufficient thickness and free from large irregularities on a SiC substrate by employing the MSE.

### [Means for Solving the Problem]

The present invention was devised to solve the aforementioned problem, and includes a step of growing single crystal SiC on a SiC substrate at a high temperature through the MSE and a step of completely evaporating remaining Si. Inventions of respective claims will now be described.

The invention of claim 1 is a method for fabricating a SiC substrate through the metastable solvent epitaxy, which comprises a crystal growing step of growing SiC crystal with a prescribed thickness on a surface of a SiC substrate at a SiC crystal growth temperature, followed by a Si evaporating step of evaporating a Si melt at a temperature between the SiC crystal growth temperature and a melting point of Si.

The present inventor conducted an experiment on the occurrence of irregularities in a surface portion of a SiC substrate during the aforementioned evaporation of the Si melt by employing the conventional MSE, resulting in finding that the size of the irregularities is in proportion to the temperature employed in the evaporation of the Si melt. Specifically, it was found that large irregularities of 10 µm or more are caused when the temperature is approximately 1800°C and irregularities of approximately 1 µm are caused when the temperature is approximately 1600°C.

That is, it was found that large irregularities in a surface portion is caused since, in the conventional MSE, the heating process is carried out at a high temperature for attaining a high crystal growth speed so as to obtain SiC crystal with a large thickness, and the evaporation of the Si melt is continuously performed.

According to the invention of this claim, on the basis of the aforementioned finding, the crystal growing step and the Si evaporating step are not performed at the same temperature as in the conventional MSE, but the crystal growing step performed at a high temperature and the Si evaporating step performed at a temperature lower than the SiC crystal growth temperature are definitely separated. Therefore, in the crystal growing step performed at a high temperature, SiC may be sufficiently grown to obtain SiC crystal with a desired thickness at a high growth speed while, in the Si evaporating step performed at the temperature lower than the SiC crystal growth temperature, the Si melt may be evaporated with suppressing the occurrence of large irregularities in the SiC crystal.

As a result, SiC crystal having a sufficient thickness and free from large irregularities in a surface portion thereof may be obtained. Since the aforementioned non-destructive thickness measurement may be easily performed on such SiC crystal and a margin for the polishing may be sufficiently controlled. Hence, the amount of a polished portion corresponding to a material loss may be reduced and time necessary for the polishing may be reduced, resulting in lowering the cost.

The SiC crystal growth temperature of the invention according to this claim may be appropriately set on the basis of, for example, the size of the SiC substrate or the desired thickness of the SiC crystal. When the temperature is too high, a harmful influence that, for example, the SiC used as the substrate or SiC of polycrystalline SiC used as a carbon atom supplying source is sublimed newly occurs,. Hence, the temperature is preferably approximately 1700 through 2200°C.

The temperature at which the Si melt is evaporated may be appropriately set in accordance with the set SiC crystal growth temperature and is preferably approximately 1450 through 1700°C.

The invention of claim 2 is a method for fabricating a SiC substrate according to claim 1, wherein ambient pressure is higher than saturation vapor pressure of the Si melt in the crystal growing step and ambient pressure is lower than the saturation vapor pressure of the Si melt in the Si evaporating step.

Since all the steps are performed in a high vacuum atmosphere in the conventional MSE as described above, the SiC crystal growth and the evaporation of the Si melt are performed in parallel. Therefore, it is apprehended that the Si melt may be completely evaporated before growing the crystal of SiC into a desired thickness. In such a case, the evaporation of the Si melt is completed at a high temperature, and hence, large irregularities are caused in a surface portion of the SiC crystal as described above. Furthermore, since the growth of the SiC is stopped, SiC crystal with a desired thickness may not be obtained.

According to the invention of this claim, since the ambient pressure is set to be higher than the saturation vapor pressure of the Si melt in the crystal growing step for suppressing the evaporation of the Si melt, it is possible to suppress complete evaporation of the Si melt and the occurrence of large irregularities in a surface portion of SiC crystal in the crystal growing step performed at a high temperature. Also, the SiC may be definitely grown into a desired thickness. Furthermore, since the ambient pressure is set to be lower than the saturation vapor pressure of the Si melt in the Si evaporating step performed at the temperature lower than the SiC crystal growth temperature, the Si melt may be rapidly and completely evaporated.

As a method for setting the ambient pressure to be higher than the saturation vapor pressure of the Si melt in the crystal growing step, for example, a method in which an inert gas such as an Ar gas (whereas nitrogen is not preferred because it is taken in by SiC), a hydrogen gas or a mixture gas of them is introduced is preferably employed.

Furthermore, in general, the ambient pressure employed in the crystal growing step is preferably 100 Pa or more in consideration of the aforementioned preferable crystal growth temperature. The ambient pressure employed in the Si evaporating step is preferably 300 Pa or less.

The invention of claim 3 is a method for fabricating a SiC substrate according to claim 2,
which further comprises, prior to the crystal growing step,
a Si melt forming step of forming the Si melt by increasing the temperature up to a temperature between the SiC crystal growth temperature and the melting point of Si in a vacuum atmosphere; and
a Si melt forming temperature keeping step of keeping the temperature of the Si melt forming step for a prescribed period of time, and is **characterized in that,** in the Si melt forming temperature keeping step, an inert gas (excluding nitrogen), a hydrogen gas or a mixture gas of them is introduced until the ambient pressure to be employed in the crystal growing step is attained.

As a method for setting the ambient pressure employed in the crystal growing step in claim 2 to be higher than the saturation vapor pressure of the Si melt, an inert gas (excluding nitrogen), a hydrogen gas or a mixture gas of them is preferably introduced.

When an inert gas or a hydrogen gas is introduced before forming the Si melt, however, bubbles of the inert gas or the hydrogen gas are unavoidably involved in the Si melt in forming the Si melt. That is, the Si melt layer may not be formed as a homogeneous Si melt layer but the Si melt layer contains bubbles. When the Si melt layer containing bubbles is used for the crystal growth, homogeneous SiC crystal may not be obtained.

Therefore, an initial stage of the temperature increase is preferably performed in a vacuum atmosphere. Furthermore, the crystal growth may be stably performed when the temperature is increased up to the temperature between the SiC crystal growth temperature and the melting point of Si, an inert gas (excluding nitrogen), a hydrogen gas or a mixture gas of them is introduced until the ambient pressure to be employed in the crystal growing step is attained while keeping the temperature, and, thereafter, the temperature is increased up to the SiC crystal growth temperature.

The invention of claim 4 is a method for fabricating a SiC substrate according to any of claims 1 through 3, wherein an amount of Si to be used is a sum of an amount of Si necessary for obtaining the SiC crystal with a prescribed thickness and an amount exceeding an amount of the Si melt evaporated in the crystal growing step.

According to the invention of this claim, not only the amount of Si necessary for obtaining SiC crystal with a prescribed thickness but also the amount of Si exceeding the amount of the Si melt expected to be evaporated in the crystal growing step is used, and therefore, even when all the steps are performed in a high vacuum atmosphere, the Si melt is not completely evaporated in the crystal growing step. Therefore, the complete evaporation of the Si melt at a high temperature may be avoided, resulting in avoiding the occurrence of large irregularities in a surface portion of the SiC crystal.

### [Effects of the Invention]

According to the present invention, single crystal SiC having a sufficient thickness and free from large irregularities in a surface portion thereof may be grown on a SiC substrate through the MSE. Furthermore, the amount of SiC to be polished in a surface portion may be reduced and the time necessary for the polishing may be reduced, resulting in lowering the cost.

### [Brief Description of Drawings]

FIG. 1 is a diagram schematically illustrating a main part of an apparatus for growing single crystal SiC employed in the MSE.
FIG. 2 is a graph illustrating a temperature profile employed in Embodiment 1 of the invention.
FIG. 3 is a diagram conceptually illustrating irregularities caused in a surface portion of single crystal SiC obtained in Embodiment 1.
FIG. 4 is a graph illustrating a temperature profile employed in Embodiment 2 of the invention.
FIG. 5 is a graph illustrating a temperature profile employed in conventional MSE.
FIG. 6 is a diagram conceptually illustrating irregularities caused in a surface portion of single crystal SiC obtained through the conventional MSE.
FIG. 7 is a graph illustrating the relationship between saturation vapor pressure of Si and a temperature.

### [Mode for Carrying Out the Invention]

The present invention will now be described on the basis of embodiments thereof. It is noted that the present invention is not limited to the embodiments described below. The following embodiments may be variously modified within the same and equivalent scope of the invention. Examples

### (EMBODIMENT 1)

In the present embodiment, after sufficiently growing SiC in a high-temperature vacuum atmosphere, a remaining Si melt is evaporated at a temperature lower than a SiC crystal growth temperature, so as to obtain a single crystal SiC substrate on which single crystal SiC has been grown.

### 1. Preparation of single crystal SiC

Single crystal SiC was prepared through steps described below.

### (1) Structure of apparatus for growing SiC

First, as illustrated in FIG. 1, a single crystal SiC substrate 10, a Si layer 20, an upper spacer 40, a carbon atom supply substrate 30 and a lower spacer 50 are disposed in this order in a downward direction in a closed crucible 60. This procedure is the same as in the conventional MSE. Incidentally, solid Si in an amount sufficiently exceeding an amount of Si necessary for obtaining SiC crystal with a desired thickness is disposed in the Si layer 20.

### (2) Temperature in crucible and atmosphere in furnace in each step

Next, the crucible 60 is heated by using heating means not shown. FIG. 2 illustrates a temperature profile employed in this embodiment.

### i) Step of initially increasing temperature

First, in a vacuum atmosphere of 300 Pa, the temperature is increased from room temperature to 1800°C at an increasing rate of 30°C/min. Through this temperature increase, the solid Si is melted to form a Si melt layer not containing bubbles when the temperature exceeds the melting point of Si (i.e., approximately 1400°C).

### ii) Step of growing crystal

Next, in a vacuum atmosphere, the temperature of 1800°C is kept for 6 hours. During this, single crystal SiC is epitaxially grown on the single crystal SiC substrate 10.

### iii) Step of evaporating Si melt

Thereafter, the temperature is lowered from 1800°C to 1600°C at a lowering rate of 5°C/min., and the temperature of 1600°C is kept for 9 hours. During this, a remaining Si melt is entirely evaporated.

### iv) Step of lowering temperature and taking out substrate

Next, the temperature is lowered from 1600°C to room temperature at a lowering rate of 1°C/min., and the single crystal SiC substrate 10 on which the single crystal SiC has been grown is taken out.

### 2. Irregularities in surface portion of prepared single crystal SiC

A surface state of the single crystal SiC on the single crystal SiC substrate thus obtained is illustrated in FIG. 3. In FIG. 3, a reference numeral 10 denotes a single crystal SiC substrate, a reference numeral 11 denotes single crystal SiC grown through the MSE, and a reference numeral 18 denotes irregularities caused in a surface portion. As illustrated in FIG. 3, the irregularities in a surface portion of the single crystal SiC in this embodiment were approximately 1 µm, and it was confirmed that the surface was very flat.

This is for the following reason: Since the solid Si is precedently provided in a sufficient amount, the Si melt remains when the step of growing crystal is completed and the Si melt is completely evaporated in the step of evaporating Si performed at the temperature lower than the crystal growth temperature, and formation of large irregularities in a surface portion of the single crystal SiC is suppressed.

### (EMBODIMENT 2)

In the present embodiment, ambient pressure employed in a step of growing crystal is set to be higher than saturation vapor pressure of a Si melt and ambient pressure employed in a step of evaporating Si is set to be lower than the saturation vapor pressure of the Si melt, so as to obtain a single crystal SiC substrate on which single crystal SiC has been grown.

Among steps of this embodiment, only steps different from those of Embodiment 1 will now be described. It is noted that FIG. 4 illustrates a temperature profile employed in this embodiment.

### (1) Atmosphere and temperature employed in each step

### i) Step of initially increasing temperature

First, the temperature is increased from room temperature to 1500°C at a rate of 30°C/min. in a vacuum atmosphere of 300 Pa, so as to form a Si melt layer by completely melting solid Si.

### ii) Step of introducing Ar gas

Next, the temperature of 1500°C is kept for 1 hour, during which Ar gas is introduced for increasing the ambient pressure up to 740 hPa sufficiently higher than saturation vapor pressure (of approximately 600 Pa) of the Si melt at 1800°C. It is noted that the relationship between the saturation vapor pressure of Si and the temperature is illustrated in a graph of FIG. 7.

Involvement of bubbles in the Si melt layer may be suppressed by introducing the Ar gas after forming the Si melt layer by increasing the temperature in a vacuum atmosphere. Furthermore, since the Ar gas is introduced until the ambient pressure to be employed in the step of growing crystal is attained prior to the step of growing crystal, the crystal may be stably grown.

### iii) Step of growing crystal

Next, while keeping the ambient pressure at 740 hPa, the temperature is increased from 1500°C to 1800°C at a rate of 30°C/min., and the temperature of 1800°C is kept thereafter for 6 hours, so as to epitaxially grow single crystal SiC on the single crystal SiC substrate. At this point, since the ambient pressure is higher than the saturation vapor pressure of the Si melt, the evaporation of the Si melt is suppressed, so that the crystal may be sufficiently grown.

### iv) Step of evaporating Si melt

Thereafter, the temperature is lowered from 1800°C to 1600°C at a lowering rate of 5°C/min., and the Ar gas is exhausted to attain a vacuum atmosphere for evaporating the Si melt. Then, the temperature of 1600°C is kept for 9 hours, so as to entirely evaporate a remaining Si melt.

### (2) Irregularities in surface portion of prepared single crystal SiC

It was confirmed that irregularities in a surface portion of the single crystal SiC thus grown on the single crystal SiC substrate have a small size in the same manner as in Embodiment 1.

This is for the following reason: Since the ambient pressure employed in the step of growing crystal is set to be higher than the saturation vapor pressure of the Si melt, the evaporation of the Si melt in the step of growing crystal is suppressed, and complete evaporation of the Si melt is carried out in the step of evaporating Si performed at a temperature lower than the crystal growth temperature, and therefore, formation of large irregularities in a surface portion of the single crystal SiC may be suppressed.

### [Description of Marks]

- 10: single crystal SiC substrate
- 11: single crystal SiC
- 18: surface portion of single crystal SiC
- 20: Si layer
- 30: carbon atom supply substrate
- 40: upper spacer
- 50: lower spacer
- 60: crucible

## Claims

1. A method for fabricating a SiC substrate through the metastable solvent epitaxy, which comprises
a crystal growing step of growing SiC crystal with a prescribed thickness on a surface of a SiC substrate at a SiC crystal growth temperature, followed by a Si evaporating step of evaporating a Si melt at a temperature between the SiC crystal growth temperature and a melting point of Si.

2. A method for fabricating a SiC substrate according to claim 1, wherein ambient pressure is higher than saturation vapor pressure of the Si melt in the crystal growing step and ambient pressure is lower than the saturation vapor pressure of the Si melt in the Si evaporating step.

3. A method for fabricating a SiC substrate according to claim 2, which further comprises, prior to the crystal growing step,
a Si melt forming step of forming the Si melt by increasing the temperature up to a temperature between the SiC crystal growth temperature and the melting point of Si in a vacuum atmosphere; and
a Si melt forming temperature keeping step of keeping the temperature of the Si melt forming step for a prescribed period of time; and is **characterized in that**, in the Si melt forming temperature keeping step, an inert gas (excluding nitrogen), a hydrogen gas or a mixture gas of them is introduced until the ambient pressure to be employed in the crystal growing step is attained.

4. A method for fabricating a SiC substrate according to any of claims 1 through 3, wherein an amount of Si to be used is a sum of an amount of Si necessary for obtaining the SiC crystal with a prescribed thickness and an amount exceeding an amount of the Si melt evaporated in the crystal growing step.
